# EUROPÄISCHE PATENTSCHRIFT

(11) **EP 0 903 823 B1**
(45) Veröffentlichungstag und Bekanntmachung des Hinweises auf die Patenterteilung: **11.12.2002**
(21) Anmeldenummer: 98116677.0
(22) Anmeldetag: 03.09.1998
(51) Int. Cl.: H01S 5/40

(54) **Laserbauelement mit einem Laserarray und Verfahren zu dessen Herstellung**
Laser element incorporating a laser array and method of fabrication
Elément laser comprenant un réseau de lasers et méthode de fabrication

(30) Priorität: 22.09.1997 DE 19741712
(43) Veröffentlichungstag der Anmeldung: 24.03.1999
(73) Patentinhaber: Osram Opto Semiconductors GmbH & Co. OHG, 93049 Regensburg (DE)
(72) Erfinder: Grötsch, Stefan, 93053 Regensburg (DE); Wicke, Markus, 93138 Lappersdorf (DE); Späth, Werner, 83607 Holzkirchen (DE); Acklin, Bruno, 93059 Regensburg (DE)
(74) Vertreter: Epping, Wilhelm, Dipl.-Ing.

(56) Entgegenhaltungen:
- EP-A- 0 735 397
- US-A- 5 268 978
- YAMAGUCHI S ET AL: "COLLIMATION OF EMISSIONS FROM A HIGH-POWER MULTISTRIPE LASER-DIODE BAR WITH MULTIPRISM ARRAY COUPLING AND FOCUSING TO A SMALL SPOT" OPTICS LETTERS,US,OPTICAL SOCIETY OF AMERICA, WASHINGTON, Bd. 20, Nr. 8, 15. April 1995 (1995-04-15), Seiten 898-900, XP000499612 ISSN: 0146-9592
- SATOSHI YAMAGUCHI ET AL: "EFFICIENT ND:YAG LASER END PUMPED BY A HIGH-POWER MULTISTRIPE LASER-DIODE BAS WIRHT MULTIPRISM ARRAY COUPLING" APPLIED OPTICS,US,OPTICAL SOCIETY OF AMERICA,WASHINGTON, Bd. 35, Nr. 9, 20. März 1996 (1996-03-20), Seiten 1430-1435, XP000559720 ISSN: 0003-6935

## Beschreibung

Die Erfindung bezieht sich auf ein Laserbauelement mit mindestens einem Laserarray und einer optischen Vorrichtung zum Umformen eines von dem Laserarray, insbesondere von einem Laserdiodenbarren ausgesandten Laserstrahlenbündels, das mindestens zwei Einzellaserstrahlen mit derselben Strahlungsrichtung aufweist, deren Strahlachsen im wesentlichen parallel zueinander verlaufen, in einer einzigen gemeinsamen Ebene liegen und einen ersten Abstand voneinander haben, wobei die optische Vorrichtung ein in Strahlungsrichtung dem Laserarray nachgeordnetes Umlenkspiegelelement aufweist, das die Einzellaserstrahlen mit jeweils gleichem Drehsinn sowohl parallel als auch senkrecht zur gemeinsamen Ebene ablenkt.

Ein derartiges Laserbauelement ist beispielsweise aus der DE 195 11 593 A1 bekannt. Hierin ist ein Laserdiodenbarren beschrieben, dem in Strahlungsrichtung ein einstückig hergestellter transparenter Spiegelblock zum Umformen des ausgesandten Strahlenbündels nachgeordnet ist. In dem Spiegelblock ist eine Spiegelreihe aus einer Mehrzahl von auf einer gemeinsamen Ebene angeordneten, parallel zueinander liegenden Reflexionsflächen ausgebildet. Die Reflexionsflächen sind senkrecht zur Strahlungsrichtung um den Abstand zwischen den Einzellaserstrahlen gegeneinander versetzt. Sie stehen derart schräg zur Strahlungsrichtung, dass sie die Einzellaserstrahlen parallel zur gemeinsamen Ebene um 90° und gleichzeitig aus dieser Ebene heraus um einen Winkel größer als 0° ablenken. Die Herstellung eines derartigen transparenten Blockes erfordert hohe Präzision und ist von daher mit einem großen technischen Aufwand verbunden. Bei unzureichender Genauigkeit bei der Herstellung der Reflexionsflächen treten im Spiegelblock erhebliche Strahlungsverluste auf.

Die Aufgabe der vorliegendem Erfindung besteht darin, ein Laserbauelement der eingangs genannten Art zu entwickeln, das technisch einfach herstellbar ist und gleichzeitig vergleichsweise geringe Strahlungsverluste aufweist.

Diese Aufgabe wird durch ein Laserbauelement mit den Merkmalen des Patentanspruches 1 gelöst. Vorteilhafte Weiterbildungen des erfindungsgemäßen Laserbauelements sind Gegenstand der Unteransprüche 2 bis 8. Ein bevorzugtes Herstellverfahren ist Gegenstand des Anspruches 9.

Erfindungsgemäß ist bei dem Laserbauelement der eingangs genannten Art vorgesehen, dass das Umlenkspiegelelement eine der Anzahl von Einzellaserstrahlen entsprechende Anzahl von zu einem Lichtleiterstreifenstapel zusammengefügten planparallelen strahlungsdurchlässigen Lichtleiterstreifen aufweist. Die Dicke dieser Lichtleiterstreifen ist kleiner als der erste Abstand zwischen den Einzellaserstrahlen. Die Lichtleiterstreifen liegen parallel zueinander und schräg zur gemeinsamen Ebene der Einzellaserstrahlen. Jedem Einzellaserstrahl ist ein Lichtleiterstreifen zugeordnet, in dessen ersten Endbereich der zugehörige Einzellaserstrahl durch eine Strahleinkoppelfläche des Lichtleiterstreifens hindurch eingekoppelt wird.

Jeder Lichtleiterstreifen weist eine in Strahlungsrichtung der Strahleinkoppelfläche nachgeordnete, die Strahlachse des jeweils zugehörigen Einzellaserstrahls schneidende Reflexionsfläche auf. Diese ist einem dem ersten gegenüberliegenden zweiten Endbereich des jeweiligen Lichtleiterstreifens zugewandt und lenkt den zugehörigen Einzellaserstrahl zum zweiten Endbereich hin um. Der zweite Endbereich weist eine Strahlauskoppelfläche auf, durch die der Einzellaserstrahl aus dem Lichtleiterstreifen wieder austritt.

Durch die Strahlführung innerhalb der Lichtleiterstreifen sind die Strahlungsverluste im erfindungsgemäßen Umlenkspiegelelement im Vergleich zu herkömmlichen Vorrichtungen der eingangs genannten Art deutlich geringer.

Die als Reflexionsflächen vorgesehenen Seitenflächen der nun vorliegenden in Draufsicht parallelogrammförmigen Lichtleiterstreifen können vor oder nach dem Zersägen mit einem reflexionssteigernden Material beschichtet werden. Im oben beschriebenen Fall sind die mit den Sägeflächen einen Winkel von 45° einschließenden kurzen Stirnflächen der Lichtleiterstreifen als Reflexionsflächen vorgesehen.

Um die Lichtleiteigenschaften der Lichtleiterstreifen zu verbessern, sind zwischen den Lichtleiterstreifen bevorzugt Klebstoffschichten mit einem geringeren Brechungsindex als das Material der Lichtleiterstreifen angeordnet, die die Lichtleiterstreifen miteinander verbinden. Bei Lichtleiterstreifen aus Glas wird dazu bevorzugt Silikon-Klebstoff verwendet.

Bei einer besonders bevorzugten Ausführungsform ist das Laserarray ein Laserdiodenbarren, der auf einer Trägerplatte mit einer ebenen Montagefläche befestigt ist. Auf der Montagefläche ist zwischen dem Laserdiodenbarren und dem Umlenkspiegelelement eine Strahlenkollimationsoptik, z. B. eine Zylinderlinse, zum Parallelisieren der vom Laserdiodenbarren ausgesandten, senkrecht zur gemeinsamen Ebene stark divergenten Einzellaserstrahlen angeordnet. Der Lichtleiterstreifenstapel liegt mit den Stufenkanten auf der Montagefläche auf, so dass die Lichtleiterstreifen schräg zur gemeinsamen Ebene der Einzellaserstrahlen liegen.

Bei einer besonders bevorzugten Weiterbildung des Laserbauelements sind alle planparallelen Lichtleiterstreifen gleich breit und gleich dick und weisen in Draufsicht auf den Lichtleiterstreifenstapel die Form von Parallelogrammen mit in Richtung der Längsachse des Lichtleiterstreifenstapels verschiedenen Längen auf. Die Lichtleiterstreifen schließen auf drei Seiten des Lichtleiterstreifenstapels bündig ab und sind derart übereinander angeordnet, dass der Lichtleiterstreifenstapel auf einer Seite eine Treppenform aufweist. Die Stirnflächen der Stufen, die als Reflexionsflächen ausgebildet sind, sind entlang der Längsachse des Lichtleiterstreifenstapels um den Abstand zwischen den Einzellaserstrahlen zueinander versetzt. Die den Stufen gegenüberliegenden Stirnflächen der Streifen sind ebenfalls als Reflexionsflächen ausgebildet.

Neben dem oben genannten Vorteil der geringeren Strahlungsverluste lässt sich darüberhinaus das erfindungsgemäße Laserbauelement mit vergleichsweise geringem Aufwand herstellen, indem zunächst eine der Zahl der Einzellaserstrahlen entsprechende Anzahl von unterschiedlich breiten, langgestreckten, für die Laserstrahlung durchlässigen planparallelen Lichtleiterstreifen übereinander gestapelt wird, derart, dass die Längsstirnflächen der Lichtleiterstreifen auf einer Seite bündig, d. h. auf gleicher Ebene liegend abschließen. Auf der dieser Seite gegenüberliegenden Seite sind die Längsstirnflächen derart zueinander versetzt, daß der Stapel eine Treppenform aufweist. Der Stapel wird dann beispielsweise im Winkel von 45° zu den Längsstirnflächen in schmale Stapelstreifen zersägt, die dann im Wesentlichen bereits die gewünschten Umlenkspiegelelemente in Form von Lichtstreifenstapel darstellen.

Weiter Vorteile und vorteilhafte Ausführungsformen ergeben sich aus dem im Folgenden beschriebenen Ausführungsbeispiel in Verbindung mit den Figuren 1 bis 6. Es zeigen
Figur 1 eine schematische Darstellung einer perspektivischen Ansicht des Ausführungsbeispiels,
Figur 2 eine schematische Darstellung einer ersten Seitenansicht des Ausführungsbeispieles,
Figur 3 eine schematische Darstellung einer zweiten Seitenansicht des Ausführungsbeispieles,
Figur 4 eine schematische Darstellung einer Draufsicht auf das Ausführungsbeispiel,
Figur 5 eine schematische Ausschnittsdarstellung eines Schnittes durch den Lichtleiterstreifenstapel des Ausführungsbeispieles,
Figur 6 eine alternative Ausführungsform der Reflexionsflächen des Lichtleiterstreifenstapels,
Figur 7 eine schematische Darstellung der Umformung des Laserstrahlenbündels mittels des Umlenkspiegelelements gemäß dem Ausführungsbeispiel und
Figuren 8a und 8b eine schematische Darstellung eines Verfahrensablaufes zum Herstellen eines Umlenkspiegelelements gemäß dem Ausführungsbeispiel.

In den Figuren sind gleiche und gleichwirkende Bestandteile jeweils mit denselben Bezugszeichen versehen.

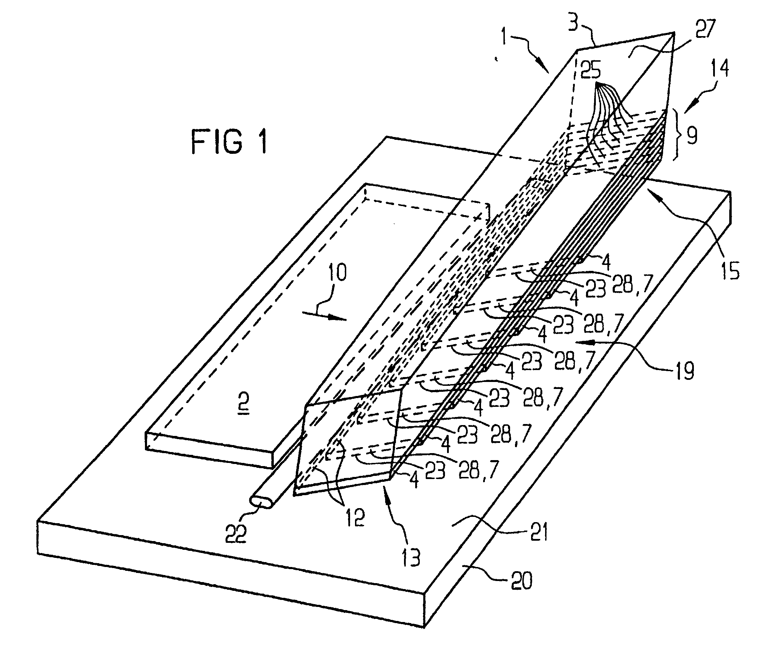

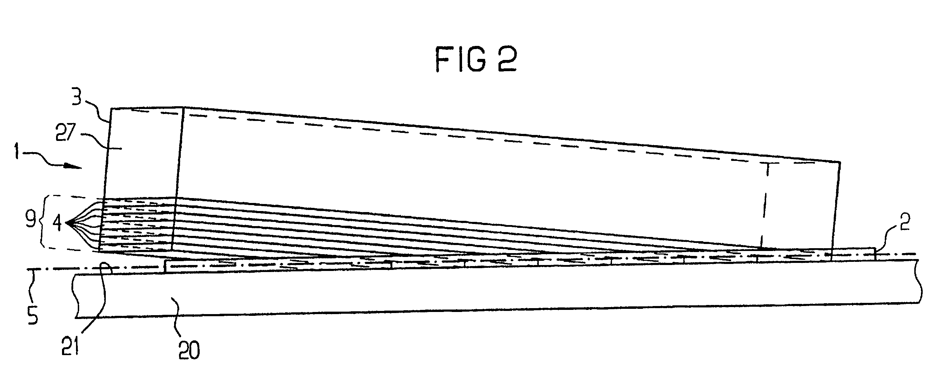

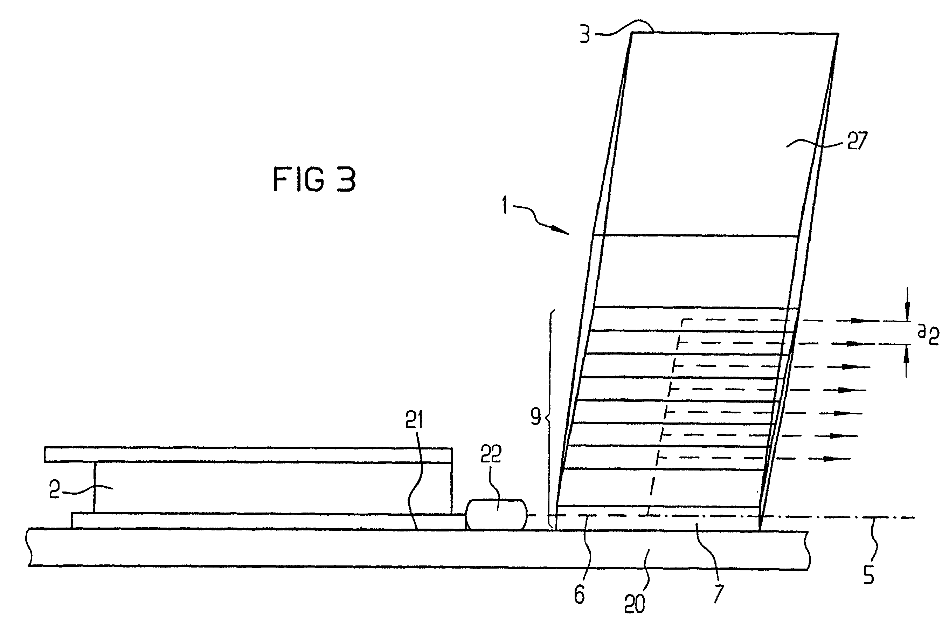

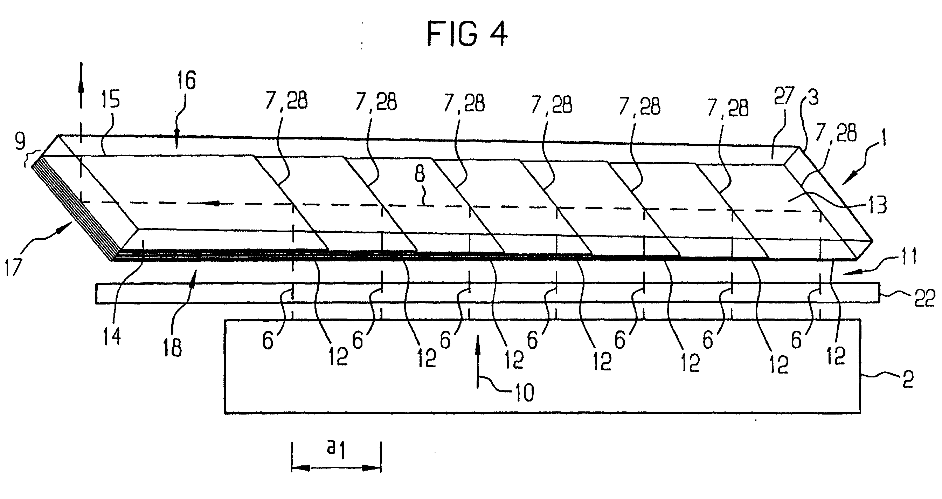

Bei dem Ausführungsbeispiel von Figur 1 bis 4 ist auf einer Montagefläche 21 einer Trägerplatte 20 ein Laserdiodenbarren 2 befestigt, der eine Anzahl von mit ihren Strahlachsen 6 in einer gemeinsamen Ebene 5 liegenden, einen ersten Abstand a1 voneinander aufweisenden Einzellaserstrahlen aussendet. Die gemeinsame Ebene 5 liegt im Wesentlichen parallel zur Montagefläche (21) der Trägerplatte 20.

Der Laserdiodenbarren 2, beispielsweise ein Hochleistungslaserdiodenbarren, weist in diesem speziellen Fall sieben streifenförmige pn-Übergänge auf, die in der gemeinsamen Ebene 5 liegen. Jeder pn-Übergang sendet einen Einzellaserstrahl mit ellipsenförmigen Querschnitt auf, dessen lange Achse parallel zum pn-Übergang und dessen kurze Achse senkrecht zu diesem verläuft. Das ausgesandte Laserstrahlenbündel besitzt daher eine sehr langgestreckte Querschnittsform. Die Einzellaserstrahlen zeigen senkrecht zur gemeinsamen Ebene 5 eine große und parallel zu dieser eine kleine Divergenz.

In Strahlungsrichtung 10 ist dem Laserdiodenbarren 2 eine Zylinderlinse 22 zur Kollimation der von dem Laserdiodenbarren 2 ausgesandten Einzellaserstrahlen senkrecht zur gemeinsamen Ebene. Der Zylinderlinse 22 ist in Strahlungsrichtung 10 ein Umlenkspiegelelement 3 nachgeordnet, das eine der Zahl von Einzellaserstrahlen entsprechende Anzahl von planparallelen Lichtleiterstreifen 4 aufweist, die beispielsweise aus Glas bestehen.

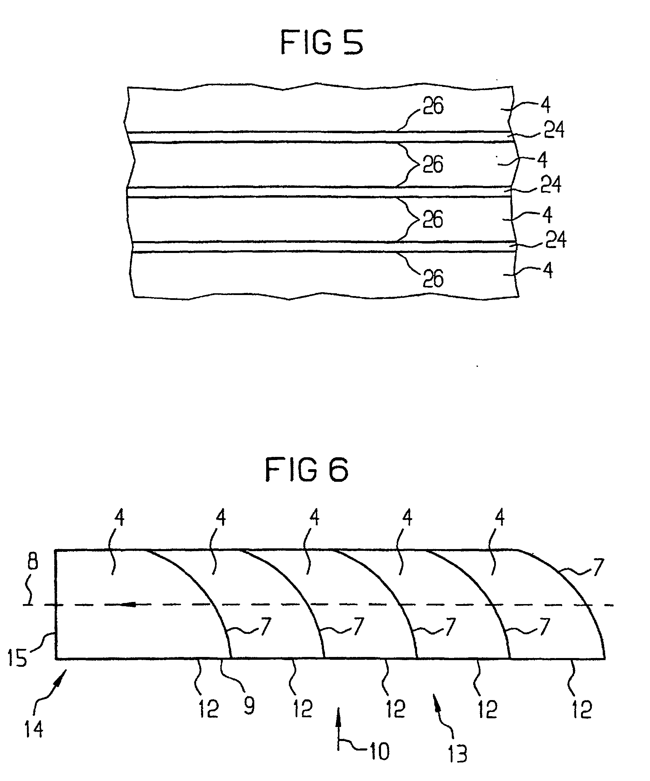

Die Lichtleiterstreifen 4 sind mit ihren Hauptflächen 26 übereinanderliegend zu einem Lichtleiterstreifenstapel 9 zusammengefügt und, wie in Figur 5 in einem vergrößerten Ausschnitt dargestellt, mittels Klebstoffschichten 24 miteinander verbunden. Die Klebstoffschichten 24 weisen zur Verbesserung der Lichtleiteigenschaften der Lichtleiterstreifen 4 bevorzugt einen geringeren Brechungsindex als das Material der Lichtleiterstreifen 4 auf und bestehen bevorzugt aus Silikon-Klebstoff.

Zur mechnischen Stabilisierung des Lichtleiterstreifenstapels 9 ist dieser auf einen Trägerstreifen 27 aufgebracht.

Die Lichtleiterstreifen 4 weisen die Form von langgestreckten Parallelogrammen (Innenwinkel 45° und 135°) auf, schließen auf drei Stirnseiten 16,17,18 des Lichtleiterstreifenstapels 9 bündig ab und sind unterschiedlich lang.

Die kurzen Stirnflächen 17,28 sind vorzugsweise mit einer reflexionssteigernden Schicht, z. B. mit einer Al-Schicht versehen sein. Als Beschichtungsverfahren kann Aufdampfen, Sputtern, CVD oder ein anderes aus der Halbleitertechnik bekanntes Verfahren angewendet werden.

Die Lichtleiterstreifen 4 sind bezüglich ihrer Längen derart übereinander angeordnet, dass der Lichtleiterstreifenstapel 9 auf einer Seite die Form einer Treppe 19 besitzt. Der Lichtleiterstreifenstapel 9 liegt mit den Stufenkanten 23 der Treppe auf der Montagefläche 21 der Trägerplatte 20 auf, derart, dass die Längsachsen 8 der Lichtleiterstreifen 4 im Wesentlichen senkrecht zur Strahlrichtung 10 der ausgesandten Einzellaserstrahlen und schräg zur Montagefläche 21 liegen. Die Stufenhöhe und -tiefe ist derart gewählt, dass jeder Lichtleiterstreifen 4 in seinem ersten, der Montagefläche 21 zugewandten Endbereich 13 mit einer Längsstirnfläche die Strahlachse 6 eines Einzellaserstrahls schneidet, derart, dass der Einzellaserstrahl mit möglichst geringen Verlusten in den Lichtleiterstreifen 4 eingekoppelt wird.

Die kurzen Stirnflächen 28 im ersten Endbereich 13 der Lichtleiterstreifen 4, also die Stirnflächen der Treppenstufen sind als erste Reflexionsflächen 7 ausgebildet, schliessen mit den Strahlachsen 6 in der gemeinsamen Ebene einen Winkel von 45° ein und sind entlang der gemeinsamen Ebene 5 sequentiell um den Abstand a1 zueinander versetzt.

Die Reflexionsflächen 7 sind den den ersten 13 gegenüberliegenden zweiten Endbereichen 14 der Lichtleiterstreifen 4 zugewandt und lenken die Einzellaserstrahlen zu den zweiten Endbereichen 14 hin um. Im Lichtleiterstreifenstapel 4 sind folglich die Einzellaserstrahlen von der gemeinsamen Ebene 5 aus gesehen mit ihren langen Achsen des Querschnitts übereinander angeordnet. Das Laserstrahlenbündel hat nach der Umlenkung durch die Reflexionsflächen 7 im wesentlichen einen rechteckigen Querschnitt.

Die den Reflexionsflächen 7 gegenüberliegenden kurzen Stirnflächen der Lichtleiterstreifen 4 sind beispielsweise mittels Reflexionsbeschichtung als weitere Reflexionsflächen 25 ausgebildet. Sie liegen alle in derselben Ebene und schneiden die Längsachsen 8 der Lichtleiterstreifen 4 im Wesentlichen in einem Winkel von 45°, so dass das Laserstrahlenbündel vor dem Auskoppeln aus dem Lichtleiterstreifenstapel 9 wieder in die ursprüngliche Strahlungsrichtung 10 der vom Laserdiodenbarren 2 ausgesandten Einzellaserstrahlen umgelenkt wird.

Bei der in Figur 6 schematisch in Draufsicht dargestellten Ausführungsform eines Lichtleiterstreifenstapel 9 sind die als Reflexionsflächen 7 ausgebildeten Stirnflächen der Treppenstufen nicht eben sondern gekrümmt, um gleichzeitig zur Ablenkung eine Kollimation der Einzellaserstrahlen zu erzielen. Weiterhin weisen hier die Lichtleiterstreifen 4 in ihren zweiten Endbereichen 14 keine weiteren Reflexionsflächen auf. Hier sind die den Reflexionsflächen 7 gegenüberliegenden Stirnflächen der Lichtleiterstreifen die Strahlauskoppelflächen 15 des Lichtleiterstreifenstapels 9. Die Strahlungsrichtung des umgeformten Laserstrahlenbündel steht damit im Wesentlichen senkrecht zur ursprünglichen Strahlungsrichtung 10 des Laserdiodenbarrens.

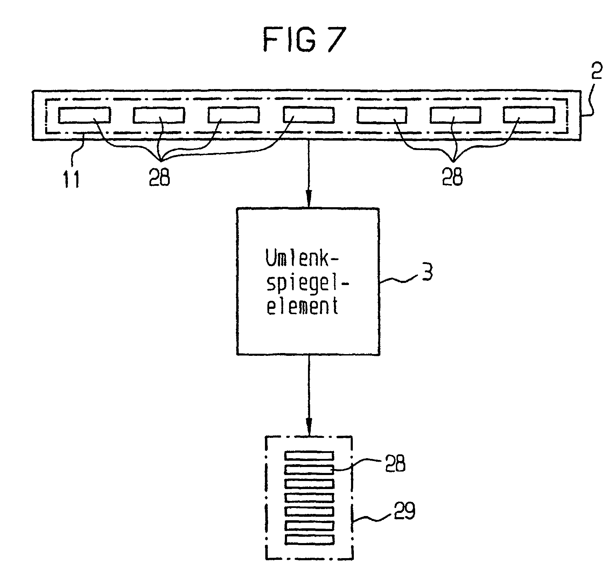

Die Figur 7 zeigt schematisch die Umformung des Laserstrahlenbündels 11 mittels des Umlenkspiegelelements 3 gemäß dem Ausführungsbeispiel und der Ausführungsform gemäß Figur 6. Das Laserstrahlenbündel 11, bestehend aus sieben vom Laserdiodenbarren 2 ausgesandten, kollimierten Einzellaserstrahlen 28 mit streifenförmigen Querschnitt wird in ein im Querschnitt rechteckiges Ausgangslaserstrahlenbündel 29 aus sieben parallel nebeneinander angeordneten im Querschnitt rechteckigen Einzellaserstrahlen 28 umgeformt. Dieses kann dann beispielsweise in eine Lichtleitfaser eingekoppelt und/oder zum Pumpen eines Festkörperlasers genutzt werden.

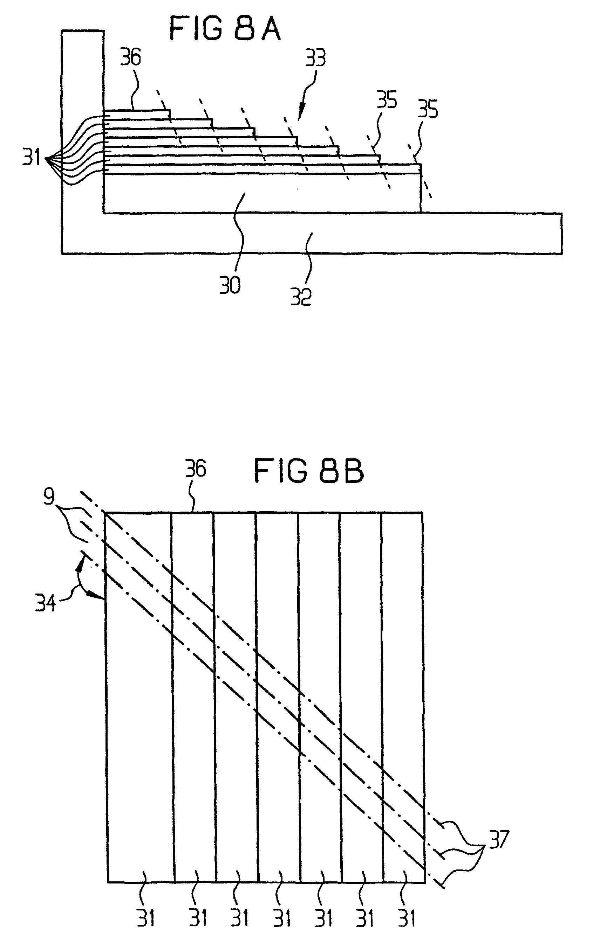

In den Figuren 8a und 8b ist ein Verfahrensablauf zum Herstellen eines Umlenkspiegelelements 3 gemäß dem Ausführungsbeispiel schematisch dargestellt. Zunächst werden in einem Anschlagwinkel 32 auf einem Si-Träger 30 sieben Glasstreifen 31 verschiedener Breite übereinander angeordnet, wobei die Breite der Glasstreifen 31 von unten nach oben kleiner wird. Die Glasstreifen werden mittels Silikon-Klebstoff miteinander verbunden. An einer senkrechten, parallel zu den Längsachsen der Glasstreifen 31 liegenden Fläche des Anschlagwinkels 32, schließen die Glasstreifen 31 bündig ab, so dass sie auf der hierzu gegenüberliegenden Seite eine Treppe 33 ausbilden (Figur 8a).

Die als Reflexionsflächen vorgesehenen Stirnflächen der Glasstreifen 31 können vor oder nach diesen Schritten mit einer Reflexionsschicht versehen werden.

Nachfolgend wird in einem Winkel 34 von 45° zu den Längsachsen der Glasstreifen entlang der in Figur 8b eingezeichneten Sägelinien 37 der Glasstreifenstapel in schmale Lichtleiterstreifenstapel 9 zersägt (Figur 8b). Die Sägeflächen werden bevorzugt nachfolgend poliert und können zusätzlich mit einer Schicht mit geringerem Brechungsindex als Glas versehen werden.

Die Stirnflächen der Stufen können, wie in Figur 8a durch die gestrichelte Linie 35 angedeutet, vorteilhafterweise geringfügig abgeschrägt sein, d. h. sie können mit den Flächennormalen der Hauptflächen der Glasstreifen einen Winkel von wenigen Grad aufweisen, um eine exaktere Umlenkung der Einzellaserstrahlen in Richtung der Längserstreckung der Lichtleiterstreifen 4 zu erreichen.

Die Lichtleiterstreifen 4 können beispielsweise aus Glas, aus transparentem Kunststoff oder aus einem für die Wellenlänge λ der von dem Laserdiodenbarren 2 ausgesandten Strahlung durchlässigen Halbleitermaterial bestehen. Für Wellenlängen λ > 400nm eignet sich z. B. SiC, für λ > 550nm z. B. GaP, für λ > 900 nm z. B. GaAs und für λ > 1100nm z. B. Si.

## Patentansprüche

1. Laserbauelement mit einem Laserarray (2) und einer optischen Vorrichtung (1) zum Umordnen eines von dem Laserarray (2) ausgesandten Laserstrahlenbündels (11),
das mindestens zwei Einzellaserstrahlen mit derselben ersten Strahlungsrichtung (10) aufweist, deren Strahlachsen (6) im wesentlichen parallel zueinander verlaufen, in einer einzigen gemeinsamen Ebene (5) liegen und einen ersten Abstand (a1) voneinander haben,
wobei die optische Vorrichtung (1) ein in Strahlungsrichtung (10) dem Laserarray (2) nachgeordnetes Umlenkspiegelelement (3) aufweist, das die Einzellaserstrahlen des ausgesandten Laserstrahlenbündels (11) mit jeweils gleichem Drehsinn sowohl parallel als auch senkrecht zur gemeinsamen Ebene (5) ablenkt,
**dadurch gekennzeichnet,**
**dass** das Umlenkspiegelelement (3) eine der Anzahl von Einzellaserstrahlen entsprechenden Anzahl von zu einem Lichtleiterstreifenstapel (9) zusammengefügten planparallelen strahlungsdurchlässigen Lichtleiterstreifen (4) aufweist,
**dass** die Dicke der Lichtleiterstreifen (4) kleiner als der erste Abstand (a1) ist,
**dass** die Lichtleiterstreifen (4) parallel zueinander und schräg zur gemeinsamen Ebene (5) der ausgesandten Einzellaserstrahlen liegen,
**dass** jedem Einzellaserstrahl ein Lichtleiterstreifen (4) zugeordnet ist, in dessen ersten Endbereich (13) der zugehörige Einzellaserstrahl durch eine Strahleinkoppelfläche (12) des Lichtleiterstreifens (4) hindurch eingekoppelt wird,
**dass** jeder Lichtleiterstreifen (4) eine in Strahlungsrichtung (10) der Strahleinkoppelfläche (12) nachgeordnete, die Strahlachse (6) des jeweils zugehörigen Einzellaserstrahls schneidende Reflexionsfläche (7) aufweist, die einem dem ersten gegenüberliegenden zweiten Endbereich (14) des zugeordneten Lichtleiterstreifens (4) zugewandt ist und den zugehörigen Einzellaserstrahl zum zweiten Endbereich (14) hin umlenkt, und
**dass** der zweite Endbereich (14) eine Strahlauskoppelfläche (15) aufweist, durch die der Einzellaserstrahl aus dem Lichtleiterstreifen (4) wieder austritt.

2. Laserbauelement nach Anspruch 1,
**dadurch gekennzeichnet,**
**dass** alle Einzellaserstrahlen des ausgesandten Laserstrahlenbündels (11) im Wesentlichen eine streifenförmige Querschnittsfläche aufweisen,
**dass** die Längsmittelachsen der Querschnittsflächen beim ausgesandten Laserstrahlenbündels (11) im Wesentlichen in der gemeinsamen Ebene (5) liegen,
**dass** sämtliche Stirnflächen (16,17,18) der Lichtleiterstreifen (4) bis auf die Reflexionsflächen (7) bündig abschließen, und
**dass** die Reflexionsflächen (7) senkrecht zur Strahlungsrichtung (10) und parallel zur gemeinsamen Ebene (5) um den ersten Abstand (a1) gegeneinander versetzt sind, so dass der Lichtleiterstreifenstapel (3) auf einer Seite eine Treppenform (19) aufweist.

3. Laserbauelement nach Anspruch 1 oder 2,
**dadurch gekennzeichnet,**
**dass** eine Längsachse (8) des Lichtleiterstreifenstapels (9) in etwa senkrecht zur Strahlungsrichtung (10) des ausgesandten Laserstrahlenbündels (11) und schräg zur gemeinsamen Ebene (5) verläuft und
**dass** die Reflexionsflächen (7) parallel zueinander liegen und mit den Strahlachsen (6) einen Winkel von etwa 45° einschließen.

4. Laserbauelement nach Anspruch 2 oder nach Anspruch 2 und 3,
**dadurch gekennzeichnet,**
**dass** das Laserarray (2) ein Laserdiodenbarren ist, der auf einer Trägerplatte (20) mit einer ebenen Montagefläche (21) befestigt ist,
**dass** auf der Montagefläche (21) zwischen dem Laserdiodenbarren und dem Umlenkspiegelelement (3) eine Strahlenkollimationsoptik (22) zum parallelisieren der vom Laserdiodenbarren ausgesandten Einzellaserstrahlen angeordnet ist und
**dass** der Lichtleiterstreifenstapel (9) mit den Stufenkanten (23) auf der Montagefläche (21) aufliegt.

5. Laserbauelement nach einem der Ansprüche 1 bis 4,
**dadurch gekennzeichnet,**
**dass** zwei benachbarte Lichtleiterstreifen (4) jeweils mittels einer Klebstoffschicht (24) miteinander verbunden sind, die einen kleineren Brechungsindex aufweist als das Material der Lichtleiterstreifen (4).

6. Laserbauelement nach Anspruch 5,
**dadurch gekennzeichnet,**
**dass** die Klebstoffschicht (24) einen Silikonklebstoff aufweist.

7. Laserbauelement nach einem der Ansprüche 1 bis 6,
**dadurch gekennzeichnet,**
**dass** jeder Lichtleiterstreifen (4) im zweiten Endbereich () eine weitere Reflexionsfläche (25) aufweist, die den zugehörigen Einzellaserstrahl vor Verlassen des Lichtleiterstreifens (4) wieder zur Strahlungsrichtung (10) der ausgesandeten Einzellaserstrahlen hin umlenkt.

8. Laserbauelement nach Anspruch 7,
**dadurch gekennzeichnet,**
**dass** die planparallelen strahlungsdurchlässigen Lichtleiterstreifen (4) gleich breit und gleich dick sind und in Draufsicht die Form von Parallelogrammen mit in Richtung der Längsachse (8) des Lichtleiterstreifenstapels (9) verschiedenen Längen aufweisen und dass die den Reflexionsflächen (7) gegenüberliegenden Stirnflächen der Lichtleiterstreifen (4) als weitere Reflexionsflächen (25) ausgebildet sind.

9. Verfahren zum Herstellen eines Lichtleiterstapels (9) zur Verwendung in einem Laserbauelement gemäß einem der Ansprüche 1 bis 8, **dadurch gekennzeichnet, dass** zunächst eine der Zahl der Einzellaserstrahlen entsprechende Anzahl von unterschiedlich breiten, langgestreckten, für die Einzellaserstrahlen durchlässigen planparallelen Glasstreifen (31) übereinander gestapelt wird, derart, dass die Längsstirnflächen der Glasstreifen (31) zumindest auf einer Seite derart zueinander versetzt sind, dass der Glasstreifenstapel (36) eine Treppenform aufweist und dass der Glasstreifenstapel (36) nachfolgend im Winkel (34) von etwa 45° zu den Längsstirnflächen in schmale Streifenstapel (9) zersägt wird.

## Claims

1. Laser component with a laser array (2) and an optical device (1) for rearranging a bundle of laser beams (11) which is emitted by the laser array (2) and has at least two individual laser beams with the same first direction of radiation (10) whose beam axes (6) run substantially parallel to one another, lie in a single common plane (5) and are at a first spacing (a1) from one another, the optical device (1) having a deflecting mirror element (3) which is downstream of the laser array (2) in the direction of radiation (10) and which deflects the individual laser beams of the emitted bundle of laser beams (11) with in each case the same sense of rotation both parallel and perpendicular to the common plane (5), **characterized in that** the deflecting mirror element (3) has a number of plane-parallel, radiation-transparent optical conductor strips (4), combined to form an optical conductor strip stack (9), which corresponds to the number of individual laser beams, **in that** the thickness of the optical conductor strips (4) is smaller than the first spacing (a1), **in that** the optical conductor strips (4) lie parallel to one another and obliquely relative to the common plane (5) of the emitted individual laser beams, **in that** each individual laser beam is assigned an optical conductor strip (4) into whose first end region (13) the associated individual laser beam is launched through a beam launching surface (12) of the optical conductor strip (4), **in that** each optical conductor strip (4) has a reflection surface (7) which is downstream of the beam launching surface (12) in the direction of radiation (10), intersects the beam axis (6) of the respective assigned individual laser beam, which faces a second end region (14), opposite the first one, of the assigned optical conductor strip (4), and deflects the associated individual laser beam towards the second end region (14) and **in that** the second end region (14) has a beam output surface (15) through which the individual laser beam re-emerges from the optical conductor strip (4).

2. Laser component according to Claim 1, **characterized in that** all the individual laser beams of the emitted bundle of laser beams (11) substantially have a strip-shaped cross-sectional surface, **in that** the longitudinal central axes of the cross-sectional surfaces lie substantially in the common plane (5) in the case of the emitted bundle of laser beams (11), **in that** all the end faces (16, 17, 18) of the optical conductor strips (4), except for the reflection surfaces (7), are terminated flush, and **in that** the reflection surfaces (7) are offset from one another perpendicular to the direction of radiation (10) and parallel to the common plane (5) by the first spacing (a1) such that the optical conductor strip stack (3) has a stepped shape (19) on one side.

3. Laser component according to Claim 1 or 2, **characterized in that** a longitudinal axis (8) of the optical conductor strip stack (9) runs approximately perpendicular to the direction of radiation (10) of the emitted bundle of laser beams (11) and obliquely relative to the common plane (5), and **in that** the reflection surfaces (7) lie parallel to one another and enclose an angle of approximately 45° with the beam axes (6).

4. Laser component according to Claim 2 or according to Claims 2 and 3, **characterized in that** the laser array (2) is a laser diode bar which is fastened on a backing plate (20) with a flat mounting surface (21), **in that** arranged on the mounting surface (21) between the laser diode bar and the deflecting mirror element (3) is a beam collimating optics (22) for parallelizing the individual laser beams emitted by the laser diode bar, and **in that** the optical conductor strip stack (9) rests on the mounting surface (21) with the stepped edges (23).

5. Laser component according to one of Claims 1 to 4, **characterized in that** two adjacent optical conductor strips (4) are connected in each case to one another by means of an adhesive layer (24) which has a smaller refractive index than the material of the optical conductor strips (4).

6. Laser component according to Claim 5, **characterized in that** the adhesive layer (24) has a silicone adhesive.

7. Laser component according to one of Claims 1 to 6, **characterized in that** each optical conductor strip (4) has in the second end region (14) a further reflection surface (25) which re-deflects the associated individual laser beam before it leaves the optical conductor strip (4) in the direction of radiation (10) of the emitted individual laser beams.

8. Laser component according to Claim 7, **characterized in that** the plane-parallel radiation-transparent optical conductor strips (4) are equally wide and equally thick and have in top view the shape of parallelograms with lengths differing in the direction of the longitudinal axis (8) of the optical conductor strip stack (9), and **in that** the end faces opposite the reflection surfaces (7) of the optical conductor strips (4) are designed as further reflection surfaces (25).

9. Method for producing an optical conductor stack (9) for use in a laser component in accordance with one of Claims 1 to 8, **characterized in that** firstly a number, corresponding to the number of individual laser beams, of elongated, plane-parallel glass strips (31) which differ in width and are transparent to the individual laser beams are stacked one above another in such a way that the longitudinal end faces of the glass strips (31) are offset from one another on at least one side in such a way that the glass strip stack (36) has a stepped shape, and **in that** the glass strip stack (36) is subsequently sawed up into narrow strip stacks (9) at an angle (34) of approximately 45° to the longitudinal end faces.

## Revendications

1. Composant laser comprenant un réseau de lasers (2) et un dispositif optique (1) pour réarranger un faisceau de rayons laser (11) émis par le réseau de lasers (2),
lequel présente au moins deux rayons laser individuels ayant le même premier sens de rayonnement (10), dont les axes de rayon (6) sont essentiellement parallèles l'un à l'autre, se trouvent dans un unique plan commun (5) et présentent un premier écart (a1) entre eux,
le dispositif optique (1) présentant un élément réfléchissant de déviation (3) disposé après le réseau de lasers (2) dans le sens du rayonnement (10), lequel dévie les rayons laser individuels du faisceau de rayons laser émis (11) à la fois parallèlement et perpendiculairement au plan commun (5) à chaque fois avec le même sens de rotation,
**caractérisé en ce**
**que** l'élément réfléchissant de déviation (3) présente un nombre de bandes de guides de lumière (4) laissant passer le rayonnement à plans parallèles regroupés en une pile de bandes de guides de lumière (9) correspondant au nombre de rayons laser individuels,
**que** l'épaisseur des bandes de guides de lumière (4) est inférieure au premier écart (a1),
**que** les bandes de guides de lumière (4) sont parallèles les unes aux autres et en biais par rapport au plan commun (5) des rayons laser individuels émis,
**qu'**à chaque rayon laser individuel est associée une bande de guides de lumière (4) dans la première zone d'extrémité (13) de laquelle est injecté le rayon laser individuel correspondant par le biais d'une surface d'injection de rayon (12) de la bande de guides de lumière (4),
**que** chaque bande de guides de lumière (4) présente une surface de réflexion (7) disposée après la surface d'injection de rayon (12) dans le sens du rayonnement (10) et coupant à chaque fois l'axe de rayon (6) du rayon laser individuel correspondant, laquelle fait face à une deuxième zone d'extrémité (14) de la bande de guides de lumière (4) opposée à la première et dévie le rayon laser individuel correspondant en direction de la deuxième zone d'extrémité (14), et
**que** la deuxième zone d'extrémité (14) présente une surface de sortie du rayon (15) à travers laquelle le rayon laser individuel ressort de la bande de guides de lumière (4).

2. Composant laser selon la revendication 1,
**caractérisé en ce**
**que** tous les rayons laser individuels du faisceau de rayons laser émis (11) présentent pour l'essentiel une surface de section stratifiée,
**que** les axes médians longitudinaux des surfaces de section se trouvent pour l'essentiel dans le plan commun (5) au niveau du faisceau de rayons laser émis (11),
**que** toutes les surfaces frontales (16, 17, 18) de la bande de guides de lumière (4) se terminent à fleur jusqu'aux surfaces de réflexion (7), et
**que** les surfaces de réflexion (7) perpendiculaires au sens du rayonnement (10) et parallèles au plan commun (5) sont décalées l'une de l'autre du premier écart (a1) de manière à ce que la pile de bandes de guides de lumière (3) présente d'un côté la forme d'un escalier (19).

3. Composant laser selon la revendication 1 ou 2,
**caractérisé en ce**
**qu'**un axe longitudinal (8) de la pile de bandes de guides de lumière (9) s'étend presque perpendiculairement au sens du rayonnement (10) du faisceau de rayons laser émis (11) et en biais par rapport au plan commun (5), et
**que** les surfaces de réflexion (7) sont parallèles l'une à l'autre et forment un angle d'environ 45° avec les axes de rayon (6).

4. Composant laser selon la revendication 2 ou selon la revendication 2 et 3, **caractérisé en ce**
**que** le réseau de lasers (2) est une barre de diodes laser qui est fixée sur une plaque support (20) qui présente une surface de montage (21) plane,
**qu'**une optique de collimation des rayons (22) destinée à mettre en parallèle les rayons laser individuels émis par la barre de diodes laser est disposée sur la surface de montage (21) entre la barre de diodes laser et l'élément réfléchissant de déviation (3), et
**que** la pile de bandes de guides de lumière (9) repose sur la surface de montage (21) avec son bord étagé (23).

5. Composant laser selon l'une des revendications 1 à 4, **caractérisé en ce**
**que** deux bandes de guides de lumière (4) voisines sont à chaque fois reliées entre elles par une couche de colle (24) qui présente un indice de réfraction inférieur à celui du matériau des bandes de guides de lumière (4).

6. Composant laser selon la revendication 5, **caractérisé en ce**
**que** la couche de colle (24) présente une colle au silicone.

7. Composant laser selon l'une des revendications 1 à 6, **caractérisé en ce**
**que** chaque bande de guides de lumière (4) présente une surface de réflexion supplémentaire (25) dans la deuxième zone d'extrémité (), laquelle dévie de nouveau le rayon laser individuel correspondant vers le sens de rayonnement (10) des rayons laser individuels émis avant de quitter la bande de guides de lumière (4).

8. Composant laser selon la revendication 7, **caractérisé en ce**
**que** les bandes de guides de lumière (4) à plans parallèles laissant passer le rayonnement sont de la même largeur et de la même épaisseur et présentent, vues de dessus, la forme de parallélogrammes de différentes longueurs dans le sens de l'axe longitudinal (8) de la pile de bandes de guides de lumière (9), et
**que** les surfaces frontales des bandes de guides de lumière (4) opposées aux surfaces de réflexion (7) sont configurées sous la forme de surfaces de réflexion supplémentaires (25).

9. Procédé pour fabriquer une pile de guides de lumière (9) destinée à être utilisée dans un composant laser selon l'une des revendications 1 à 8, **caractérisé en ce qu'**un certain nombre de bandes en verre (31) à plans parallèles, laissant passer les rayons laser et de largeurs différentes, correspondant au nombre de rayons laser individuels, sont tout d'abord empilées les unes sur les autres de manière à ce que les surfaces frontales longitudinales des bandes en verre (31) sont décalées les unes par rapport aux autres au moins sur un côté de manière à ce que la pile de bandes en verre (36) présente la forme d'un escalier et que la pile de bandes en verre (36) est ensuite partagée en minces piles de bandes (9) à un angle (34) d'environ 45° par rapport aux surfaces frontales longitudinales.
